# EUROPEAN PATENT APPLICATION

(11) **EP 4 641 570 A1**
(43) Date of publication of application: **29.10.2025**
(21) Application number: 25171066.1
(22) Date of filing: 16.04.2025
(51) Int. Cl.: G11C 8/08, G11C 8/14, G11C 5/02, G11C 7/02, G11C 11/408, G11C 7/12, G11C 7/18, G11C 8/10

(54) **MEMORY DEVICE USING WORDLINE DRIVERS WITH CROSSING ROW OUTPUTS**

(30) Priority: 22.04.2024 US 202463637284 P; 25.07.2024 US 202418784678
(71) Applicant: Micron Technology, Inc., Boise, ID 83707 (US)
(72) Inventor: BARMON, Erik, Boise, 83707 (US); FARAONI, Emiliano, Boise, 83707 (US); SHAH, Jimit, Boise, 83707 (US)
(74) Representative: Pio, Federico

(57) **Abstract**

Systems, methods, and apparatus related to memory devices. In one approach, a memory device includes wordlines connected to rows of memory cells in a memory array. Driver circuitry applies voltages to the wordlines for accessing data stored in the memory cells. A row ordering for the wordlines is implemented with non-aligned logical-to-physical addressing so that wordlines on opposite sides of individual drivers are not physically aligned in the memory array.

## Description

### FIELD OF THE TECHNOLOGY

At least some embodiments disclosed herein relate to memory devices in general, and more particularly, but not limited to memory devices that use non-aligned addressing of access lines for one or more memory arrays.

### BACKGROUND

Memory devices can include semiconductor circuits that provide electronic storage of data for a host system (e.g., a server or other computing device). Memory devices may be volatile or non-volatile. Volatile memory requires power to maintain data, and includes devices such as random-access memory (RAM), static random-access memory (SRAM), dynamic random-access memory (DRAM), or synchronous dynamic random-access memory (SDRAM), among others. Non-volatile memory can retain stored data when not powered, and includes devices such as flash memory, read-only memory (ROM), electrically erasable programmable ROM (EEPROM), erasable programmable ROM (EPROM), resistance variable memory, such as phase change random access memory (PCRAM), resistive random-access memory (RRAM), or magnetoresistive random access memory (MRAM), among others.

Host systems (e.g., a host device) can include a host processor, a first amount of host memory (e.g., main memory, often volatile memory, such as DRAM) to support the host processor, and one or more storage systems (e.g., non-volatile memory, such as flash memory) that provide additional storage to retain data in addition to or separate from the main memory.

A storage system, such as a solid-state drive (SSD), can include a memory controller and one or more memory devices, including a number of (e.g., multiple) dies or logical units (LUNs). In certain examples, each die can include a number of memory arrays and peripheral circuitry thereon, such as die logic or a die processor. The memory controller can include interface circuitry configured to communicate with a host device (e.g., the host processor or interface circuitry) through a communication interface (e.g., a bidirectional parallel or serial communication interface). The memory controller can, for example, receive commands or operations from the host system in association with memory operations or instructions, such as read or write operations to transfer data (e.g., user data and associated integrity data, such as error data or address data, etc.) between the memory devices and the host device, erase operations to erase data from the memory devices, perform drive management operations (e.g., data migration, garbage collection, block retirement), etc.

Many memory devices, particularly non-volatile memory devices, such as NAND flash devices, etc., frequently relocate data or otherwise manage data in the memory devices (e.g., garbage collection, wear leveling, drive management, etc.). NAND flash is a type of flash memory constructed using NAND logic gates. Alternatively, NOR flash is a type of flash memory constructed using NOR logic gates.

Volatile memory devices such as DRAM typically refresh stored data. For example, refresh is activating and then precharging a row. At activation time the data in the cells are sensed (implicitly read), and at precharge time the data is written back to the cells (implicitly written).

Storage devices can have controllers that receive data access requests from host computers and perform programmed computing tasks to implement the requests in ways that may be specific to the media and structure configured in the storage devices. In one example, a flash memory controller manages data stored in flash memory and communicates with a computing device. In some cases, flash memory controllers are used in solid-state drives for use in mobile devices, or in SD cards or similar media for use in digital cameras.

Firmware can be used to operate a flash memory controller for a particular storage device. In one example, when a computer system or device reads data from or writes data to a flash memory device, it communicates with the flash memory controller.

Various techniques exist for extending the life of memory cells and balancing memory usage in memory devices. Memory management technologies may be enhanced to reduce the amount of memory resources utilized to conduct memory management, reduce errors in data and error correction bits, and further extend the life of memory.

### BRIEF DESCRIPTION OF THE DRAWINGS

The embodiments are illustrated by way of example and not limitation in the figures of the accompanying drawings in which like references indicate similar elements.
**FIG. 1** shows a memory device having driver circuitry connected to access lines of one or more memory arrays using non-aligned outputs, in accordance with some embodiments.
**FIG. 2** shows sense amplifier latches to hold data associated with memory cells of a memory array, in accordance with some embodiments.
**FIG. 3A** shows logical addressing for pairs of left and right wordlines that are connected to wordline drivers and are aligned.
**FIG. 3B** shows logical addressing for pairs of left and right wordlines that are connected to wordline drivers and are not aligned, in accordance with some embodiments.
**FIG. 4** shows access lines connected to drivers using crossovers, in accordance with some embodiments.
**FIG. 5** shows wordline drivers having crossing outputs connected to wordlines, in accordance with some embodiments.
**FIG. 6** shows a method for activating a row in a memory array to read stored data, in accordance with some embodiments.

### SUMMARY

The invention is as defined in independent claims; optional embodiments are defined in dependent claims.

### DETAILED DESCRIPTION

The following disclosure describes various embodiments for memory devices that use non-aligned addressing of access lines for one or more memory arrays. At least some embodiments herein relate to a memory device that uses crossing outputs from wordline drivers so that the left and right wordlines of each row in a memory array are not aligned when the row is activated. The memory devices may include, for example, volatile (e.g., DRAM) and non-volatile (e.g., NAND or NOR flash, ferroelectric RAM) devices. These memory devices may, for example, store data used by a host device (e.g., a computing device of an autonomous vehicle, or another computing device that accesses data stored in the memory device). In one example, the memory device is a solid-state drive mounted in an electric vehicle.

Memory devices in general exhibit electrical coupling during operation. Electrical coupling is the transfer of electrical energy from one body or component of the device to another (e.g., coupling of adjacent wordlines). In memory chips this is often unwanted because the memory chip operates based on various electrical signals. It is desired that these signals do not influence the electrical behavior of nearby electrical bodies.

For example, wordline-to-wordline coupling can be a significant issue in existing memory devices (e.g., ferroelectric RAM). Due to the physical effects of shrinking manufacturing process geometries and the need for increasingly faster latency times, there is a need for improved approaches to prevent data corruption in other parts of the memory.

In one example, when using an activate command on a non-volatile memory die, the voltage of a target wordline being activated rises rapidly. The wordline voltage rises sufficiently high that access devices for the target row of the target wordline are turned on, and data stored in the cells attached to the access devices is loaded into sense amplifiers. However, if the target (aggressor) wordline voltage rises rapidly, then adjacent (victim) wordlines (which are deselected and not intended to be turned on) will have their voltages raised through electrical coupling with the target wordline. If the coupling is sufficiently large, then the access devices of the victim (deselected) wordline will turn on. This can result in data corruption in both the target row and in the deselected row.

Typically, the deselected (victim) row is driven to a low voltage in order to keep the access devices disabled. In some cases, to reduce the footprint of a memory die, only a single driver is used to drive two deselected wordlines for each row in an array (e.g., left and right wordlines on opposite sides of the driver) to this low (off) voltage. If both of the deselected wordlines are coupled (to an active row) simultaneously, then this single wordline driver must pull down (or discharge) both of the deselected wordlines at the same time, which can limit latency and reliability (e.g., due to the increased load on the driver).

In one example, a DRAM device has wordlines that are laid out closely together. It is desired to activate a single wordline at a time during a read operation. When sensing, the sense amplifiers should only be accessing memory cells of a single row activated by a single wordline. If a second adjacent wordline is activated even partially due to undesired coupling, there is a contention between two rows of cells being measured by the sense amplifiers, which can cause read or other errors.

For example, the active wordline voltage is driven to 3 V. The adjacent wordline may undesirably increase to a voltage of 0.2 V due to coupling. The driver on the adjacent wordline works hard to pull the adjacent wordline back down to 0 V. For example, during an activate command, after the active wordline is fully charged (and undesired coupling ends), the adjacent wordline driver discharges or pulls the adjacent wordline back down to zero volts.

At least some aspects of the present disclosure address the above and other deficiencies (e.g., avoid or reduce the need for a single wordline driver to pull down two adjacent and coupled wordlines at the same time) by providing a memory device using non-aligned logical-to-physical addressing for the wordlines or other access lines (e.g., bitlines or digit lines) in a memory array. For example, this prevents any single wordline driver (such as described above) from being forced to simultaneously pull down two coupled victim wordlines.

In one embodiment, a memory device has driver circuitry that connects drivers to wordlines. Each row of a memory array having left and right patches has a left wordline in the left patch and a right wordline in the right patch. Memory cells on an activated row are accessed by charging the selected left and right wordline using one of the drivers. All of the wordlines in the array are configured with a non-aligned logical-to-physical addressing. For example, some or all of the wordlines are configured so that activated left and right wordlines are never aligned. This avoids the problem described above of a single driver needing to discharge left and right victim wordlines at the same time.

In one embodiment, a memory device has access lines configured to provide access to rows of memory cells. Driver circuitry is configured to drive voltages on the access lines. Pairs of the access lines (e.g., each pair has a left wordline and a right wordline) are driven to access respective rows of an array. The two access lines of each pair are not longitudinally aligned with each other when activated to access the row corresponding to the pair. For example, the longitudinal dimensions of the left and right wordlines of each pair are physically offset (do not linearly align) from one another in the layout for a chip instead of being laid out as aligned and directly across from one another.

In one embodiment, a logical-to-physical address ordering is implemented so that a logical address order (e.g., 0, 1, 2, 3, 4, 5, 6, 7, 8) of the wordlines on a left side of driver circuitry is different from a logical address order (e.g., 4, 2, 5, 1, 7, 3, 8, 6, 0) of wordlines on an opposite right side of the driver circuitry.

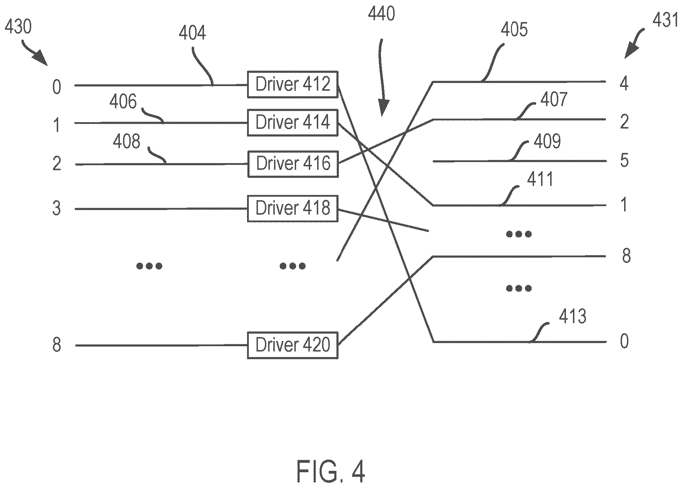

In one embodiment, the driver circuitry is a set of drivers in a layout using a linear arrangement of drivers (e.g., a series of drivers as shown in **FIG. 4**). Each driver has two outputs, with each output connected to a left or right wordline that are not aligned. The left and right wordlines are not aligned due to using crossovers connecting the driver outputs to the wordlines. For example, each crossover uses one or more vias or bridges that enable a first wordline in a right patch connected to a first driver output to physically cross one or more second wordlines in the right patch. The crossovers permit having a different logical row address ordering for the left and right patches.

In one embodiment, a memory device arranges wordlines logically in different manners (e.g., various non-aligned wordline orderings) across two patches of cells in a memory die when wordlines from both patches are driven by a common set of wordline drivers. This arrangement prevents any one wordline driver from being forced to compensate for the coupling of a row from both patches (e.g., left and right patches) at the same time. This allows for the wordline driver to be reduced in size, which reduces the cost and footprint of the memory die and/or increasing the reliability of the memory die.

As mentioned above, electrical coupling affects neighboring electrical nodes. By moving a deselected wordline connected to a wordline driver in one patch (e.g., right patch) sufficiently away from an aggressor wordline being activated, this prevents the deselected wordline from having its voltage raised due to electrical coupling. This leaves only the adjacent wordline (that is adjacent to the aggressor activated wordline) on the other patch (e.g., left patch) to continue experiencing electrical coupling. This coupling is more readily handled by the memory device since the wordline driver for the adjacent wordline must only discharge the voltage in one wordline (e.g., left adjacent wordline) instead of two wordlines (e.g., both left and right adjacent wordlines).

In one embodiment, a non-volatile RAM device uses wordline drivers for deselected rows that each pull two non-aligned wordlines (e.g., left and right) simultaneously to an off voltage (e.g., 0 V) low enough to prevent access devices on the deselected rows from turning on. For example, one of these wordlines exists in a patch of cells to the left of the driver, and one wordline exists in a patch of cells to the right of the driver. Outputs from the drivers are physically configured (e.g., using crossovers) to change an ordering of the row addresses. This routes the driver signals applied to wordlines so that any given single wordline driver for an adjacent victim wordline never has to compensate for two wordlines simultaneously while an aggressor row is activated.

In one embodiment, driver circuitry includes a series of wordline driver circuits, with each wordline driver circuit powering two wordlines (e.g., left and right). In response to an activate command, a controller causes multiple target wordlines (e.g., left and right) to be charged rapidly at the same time.

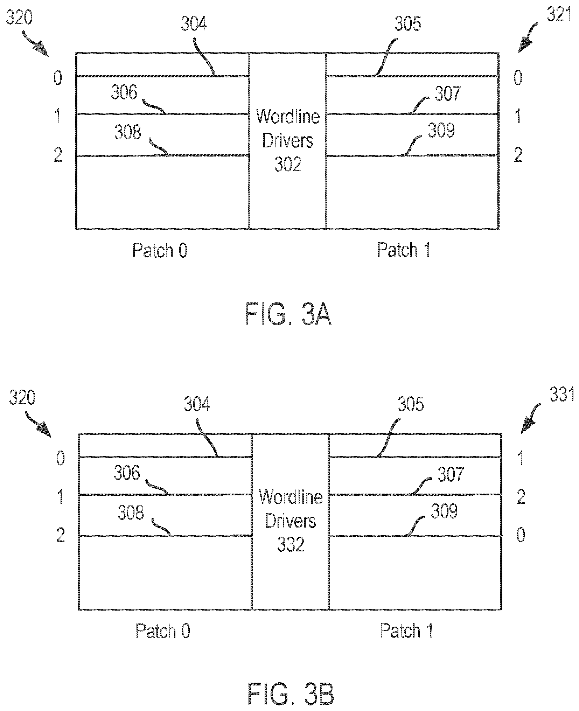

In one embodiment, the problem of victim wordlines both being disturbed by electrical coupling from the activated wordlines and driven by a single wordline driver is avoided by using crossover routing from outputs of the wordline drivers on one of two patches (e.g., patch 1 of **FIG. 3B**). For example, this row arrangement (e.g., in patch 1) routes the adjacent wordline on the right side so it is powered by a different wordline driver than the adjacent wordline on the left side (e.g., in patch 0).

In one example, a memory device includes at least one memory array and at least one controller. Wordlines are connected to drivers using crossover signal routing as described above. The controller performs read and write operations for data in the memory array using error correction. The read and write operations use error correction circuitry (e.g., an ECC engine). In one example, the memory array is configured in a volatile memory device (e.g., DRAM), and stored data is scrubbed as part of an error check and scrub (ECS) operation.

Various advantages are provided by at least some embodiments described herein. For example, the amount of charge any given single wordline driver in a memory die will need to pull at a single point in time is reduced. Reliability is improved by reducing occurrences of a memory die fail due to electrical coupling between adjacent wordlines. Also, the footprint area of the die can be reduced (e.g., reducing sizing of the wordline driver, increasing the length of the wordlines, and placing wordlines physically closer to each other).

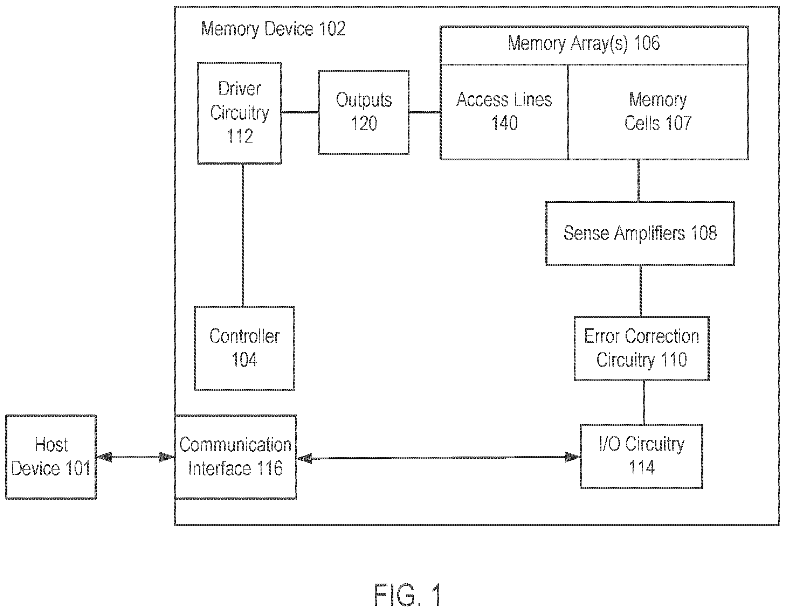

**FIG. 1** shows a memory device 102 having driver circuitry 112 connected to access lines 140 of one or more memory arrays 106 using outputs 120, in accordance with some embodiments. In one example, access lines 140 are wordlines.

Error correction circuitry 110 services read and write operations. For example, the read or write operations are performed in response to commands or other signals received from host device 101.

Controller 104 accesses portions of memory array(s) 106 in response to commands received from host device 101 via communication interface 116. Sense amplifiers 108 sense data stored in memory cells 107 of memory arrays 106. Controller 104 accesses the stored data by activating one or more rows in the memory arrays 106 (e.g., by activating left and right wordlines in a pair as discussed above). In one example, the activated rows correspond to a page of stored data.

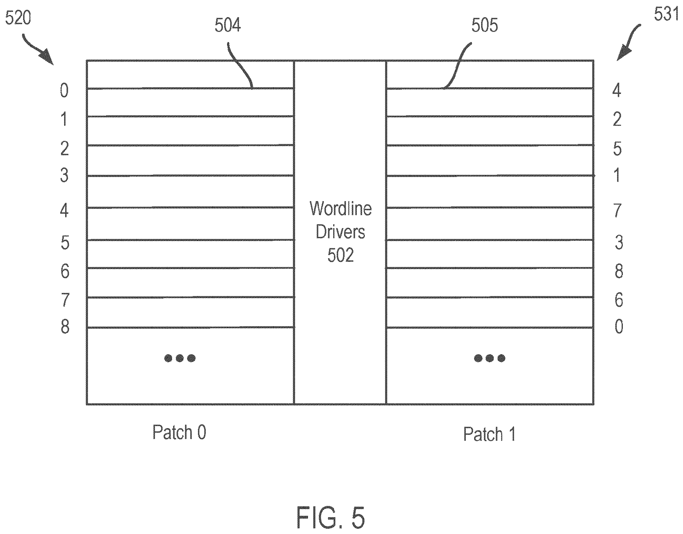

In one embodiment, driver circuitry 112 includes a series of drivers. Each driver has outputs connected to access lines. Logical row addressing for the physical access lines 140 in a first portion of memory cells (e.g., patch 0) is different from the logical row addressing for the physical access lines 140 in a second portion of memory cells (e.g., patch 1) (e.g., as shown in **FIG. 5**).

When a row of memory array 106 is activated, data can be read from the row as part of a read or other operation (e.g., wear leveling). Error correction circuitry 110 is used to detect and correct any errors identified in the accessed data on the row for a read requested by host device 101. Corrected read data is provided for output on communication interface 116 by I/O circuitry 114.

In one embodiment, communication interface (I/F) 116 is a bi-directional parallel or serial communication interface. The host device 101 can include a host processor (e.g., a host central processing unit (CPU) or other processor or processing circuitry, such as a memory management unit (MMU), interface circuitry, etc.).

In one embodiment, memory arrays 106 can be configured in a number of non-volatile memory devices (e.g., dies or LUNs), such as one or more stacked flash memory devices each including non-volatile memory (NVM) having one or more groups of non-volatile memory cells and a local device controller or other periphery circuitry thereon (e.g., device logic, etc.), and controlled by controller 104 over an internal storage-system communication interface (e.g., an Open NAND Flash Interface (ONFI) bus, etc.) separate from the communication interface 116.

In one embodiment, each memory cell in a NOR, NAND, 3D Cross Point, MRAM, or one or more other architecture semiconductor memory array 106 can be programmed individually or collectively to one or a number of programmed states. A single-level cell (SLC) can represent one bit of data per cell in one of two programmed states (e.g., 1 or 0). A multi-level cell (MLC) can represent two or more bits of data per cell in a number of programmed states (e.g., 2ⁿ, where n is the number of bits of data). In certain examples, MLC can refer to a memory cell that can store two bits of data in one of 4 programmed states. A triple-level cell (TLC) can represent three bits of data per cell in one of 8 programmed states. A quad-level cell (QLC) can represent four bits of data per cell in one of 16 programmed states. In other examples, MLC can refer to any memory cell that can store more than one bit of data per cell, including TLC and QLC, etc.

The controller 104 can receive instructions from the host device 101, and can transfer data to (e.g., write or erase) or from (e.g., read) one or more of the memory cells of the memory arrays 106. The controller 104 can include, among other things, circuitry or firmware, such as a number of components or integrated circuits. For example, the controller 104 can include one or more memory control units, circuits, or components configured to control access across the memory array and to provide a translation layer between the host device 101 and a storage system, such as a memory manager, one or more memory management tables, etc.

In one embodiment, controller 104 can include circuitry or firmware, such as a number of components or integrated circuits associated with various memory management functions, including, among other functions, wear leveling, error detection or correction, bank or block retirement, or one or more other memory management functions.

In one embodiment, controller 104 can include a set of management tables configured to maintain various information associated with one or more components of memory device 102 (e.g., various information associated with a memory array or one or more memory cells coupled to controller 104). For example, the management tables can include information regarding bank or block age, block erase count, error history, or one or more error counts (e.g., a write operation error count, a read bit error count, a read operation error count, an erase error count, etc.) for one or more banks or blocks of memory cells coupled to the controller 104. In certain examples, if the number of detected errors for one or more of the error counts is above a threshold, the bit error can be referred to as an uncorrectable bit error. The management tables can maintain a count of correctable or uncorrectable bit errors, among other things.

In one embodiment, memory device 102 can include one or more three-dimensional (e.g., 3D NAND) architecture semiconductor memory arrays 106. The memory arrays 106 can include a number of memory cells arranged in, for example, banks, a number of devices, planes, blocks, physical pages, super blocks, or super pages. As one example, a TLC memory device can include 18,592 bytes (B) of data per page, 1536 pages per block, 548 blocks per plane, and 4 planes per device.

In one embodiment, data can be written to or read from the memory device 102 in pages. However, one or more memory operations (e.g., read, write, erase, etc.) can be performed on larger or smaller groups of memory cells, as desired. For example, a partial update of tagged data from an offload unit can be collected during data migration or garbage collection to ensure it was re-written efficiently.

In one example, a page of data includes a number of bytes of user data (e.g., a data payload) and its corresponding metadata. As an example, a page of data may include 4 kB of user data as well as a number of bytes (e.g., 32B, 54B, 224B, etc.) of auxiliary or metadata corresponding to the user data, such as integrity data (e.g., error detecting or correcting code data), address data (e.g., logical address data, etc.), or other metadata associated with the user data. Different types of memory cells or memory arrays can provide for different page sizes, or may require different amounts of metadata associated therewith.

In one embodiment, a page is accessed by activating a row in memory array 106. An error in the accessed page is detected using a code word ECC engine or other error correction circuitry 110. In one example, one or more parity bits are used to check for errors in the page. Other error detection schemes can be used.

In one example, the page contains multiple code words 0, 1, ... 2ⁿ-1. In one embodiment, data stored in the code words of the page includes both user data and parity data stored for each code word.

Each page in the memory array has multiple columns [n:0]. Data being read from or written to the page is addressed by a row address and a column address. The row address corresponds to a wordline that is activated to access data stored in the page. The column address is used by a column decoder to select a column for memory cells containing the data to be accessed.

During a read operation, data read from the page is processed by the code word ECC engine to detect and correct errors. Corrected data is, for example, communicated to a host device via a data path to input/output pins (e.g., DQ pins).

In one example, when an activate command is issued, the page is sensed, and the page's data is stored in sense amplifier latches.

In one example, a memory management operation is allocated to scrub the page. The scrub uses error correction circuitry where each code word is scrubbed one at a time (e.g., the corrected data is written back into the scrub holding register one code word at a time).

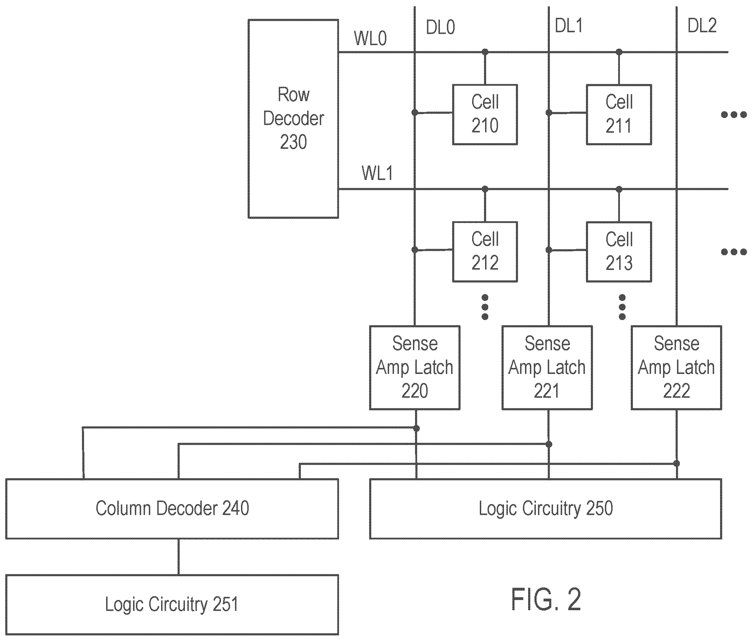

**FIG. 2** shows sense amplifier (amp) latches 220, 221, 222 to hold data associated with memory cells 210, 211, 212, 213 of a memory array, in accordance with some embodiments. In one example, the memory cells are located in memory array 106. The memory cells can be of various memory types including volatile and/or non-volatile memory cells.

The memory cells are accessed using wordlines (e.g., WL0) and digit lines (e.g., DL0) or bit lines. An individual memory cell is accessed by activating a wordline selected by row decoder 230 and selecting a digit line or bit line selected by column decoder 240. When a wordline is activated, data from each memory cell on a row resides in the corresponding sense amplifier latch for each digit line or bit line.

Data residing in the sense amplifier latches can be used as inputs to logic circuitry 250, 251 for various computations. These can include using parity or other metadata stored with the memory cells to detect and/or correct errors in the data retrieved from the memory cells. In one embodiment, logic circuitry 250 includes error correction circuitry. In one example, logic circuitry 250 is arbitrary logic that operates on data at the page level.

Logic circuitry 251 is coupled to column decoder 240. In one embodiment, logic circuitry 251 includes error correction circuitry 110. In one example, logic circuitry 251 is arbitrary logic that operates on data at the column (e.g., code word) level (e.g., using ECC engine).

In one embodiment, a memory device including a memory array has a plurality of memory cells 210, 211, 212, 213, etc., and one or more circuits or components to provide communication with, or perform one or more memory operations on, the memory array. A single memory array or additional memory arrays, dies, or LUNs can be used. The memory device can include row decoder 230, column decoder 240, sense amplifiers, a page buffer, a selector, an input/output (I/O) circuit, and a controller.

In some non-volatile memory devices (e.g., NAND flash), the memory cells of the memory array can be arranged in blocks. Each block can include sub-blocks. Each sub-block can include a number of physical pages, each page including a number of memory cells. In some examples, the memory cells can be arranged in a number of rows, columns, pages, patches, sub-blocks, blocks, etc., and accessed using, for example, access lines, data lines, or one or more select gates, source lines, etc.

In volatile memory devices (e.g., DRAM) and some emerging non-volatile memory technologies, the memory cells of the memory array can be arranged in banks or other forms of partition. In one example, when an activate to a row address is issued, the row address may be addressed by addressing bits on the activate command using a bank address (to specify which bank within the memory device), and a row address (to specify which row within the specified bank). The wordline associated with the row address is brought high.

A controller (e.g., controller 104) can control memory operations of the memory device according to one or more signals or instructions received on control lines (e.g., from host device 101) including, for example, one or more clock signals or control signals that indicate a desired operation (e.g., write, read, erase, etc.), or address signals (A0-AX) received on one or more address lines. One or more devices external to the memory device can control the values of the control signals on the control lines, or the address signals on the address line. Examples of devices external to the memory device can include, but are not limited to, a host, a memory controller, a processor, or one or more circuits or components.

The memory device can use access lines and data lines to transfer data to (e.g., write or erase) or from (e.g., read) one or more of the memory cells. The row decoder and the column decoder can receive and decode the address signals (A0-AX) from the address line, can determine which of the memory cells are to be accessed, and can provide signals to one or more of the access lines (e.g., one or more of a plurality of wordlines (e.g., WL0-WLm)) or the data lines (e.g., one or more of a plurality of bit lines (BL0-BLn).

The memory device can include sense circuitry, such as sense amplifiers 108, configured to determine the values of data on (e.g., read), or to determine the values of data to be written to, the memory cells using the data lines. In one example, sense amplifiers are used to sense voltage (e.g., in the case of charge sharing in DRAM). In one example, in selected memory cells, one or more of the sense amplifiers can read a logic level in the selected memory cell in response to a read current flowing in the memory array through the selected cell(s) to the data line(s).

One or more devices external to the memory device can communicate with the memory device using I/O lines (e.g., DQ0-DQN), address lines (e.g., A0-AX), or control lines. I/O circuitry (e.g., 114) can transfer values of data in or out of the memory device, such as in or out of the page buffer or the memory array, using the I/O lines, according to, for example, the control lines and address lines. The page buffer can store data received from the one or more devices external to the memory device before the data is programmed into relevant portions of the memory array, or can store data read from the memory array before the data is transmitted to the one or more devices external to the memory device.

The column decoder 240 can receive and decode address signals (e.g., A0-AX) into one or more column select signals (e.g., CSEL1-CSELn). The selector (e.g., a select circuit) can receive the column select signals (CSEL1-CSELn) and select data in the page buffer representing values of data to be read from or to be programmed into memory cells. Selected data can be transferred between the page buffer and the I/O circuitry.

**FIG. 3A** shows logical addressing for pairs of left and right wordlines that are connected to wordline drivers 302 and are aligned. For example, left wordline 304 and right wordline 305 together provide a pair of wordlines that is activated when accessing logical row 0. Wordlines 306, 307 and wordlines 308, 309 are similarly-used pairs to access logical rows 1, 2.

The logical row ordering 320 for the left portion of the memory array corresponds to the physical left wordlines in patch 0. The logical row ordering 321 for the right portion of the memory array corresponds to the physical right wordlines in patch 1. The logical row orderings 320, 321 are the same.

The wordlines 304, 305 are longitudinally aligned in layout with each other. For example, wordline 308 is aligned with wordline 309 for the same logical row 2. This alignment is for two wordlines on opposite sides of wordline drivers 302.

When logical row 0 is accessed, wordlines 304, 305 are activated and become aggressor wordlines that cause coupling with adjacent wordlines 306, 307. Wordlines 304, 305 are driven by a single driver. Wordlines 306, 307 are driven by a different single driver. Because both wordlines 306, 307 are victim wordlines coupled to the aggressor wordlines, the different single driver is placed under a heavy wordline discharge load (e.g., as described above). This can lead, for example, to read errors as discussed above.

**FIG. 3B** shows logical addressing for pairs of left and right wordlines that are connected to wordline drivers 332 and are not aligned, in accordance with some embodiments. Wordline drivers 332 are an example of driver circuitry 112. Wordlines 304, 305, 306, 307 are an example of access lines 140.

For example, physical routing from outputs of drivers 332 is different from the routing used in wordline drivers 302. The routing from drivers 332 permits each single driver to drive left and right wordlines that are not aligned across wordline drivers 332.

As an example, the physical routing from drivers 332 uses crossovers (not shown) (see, e.g., crossovers 440 of **FIG. 4**) that permit physical routing from the outputs of the drivers 332 to wordlines 305 and 309 to cross over one another. This permits having the changed logical row address ordering 331. Thus, the outputs from the drivers to wordlines in patch 1 can deliver the correct signals to the correct rows due to use of the crossovers. For example, in **FIG. 3A****,** row 0 is addressed by driving wordlines 304 and 305. **FIG. 3B** changes the physical routing of the driver outputs to drive address row 0 by driving wordlines 304 and 309 using the crossovers.

In one example, when logical row 0 is activated, a single driver activates wordlines 304, 309. A different single driver deselects or discharges wordlines 305, 306. Yet another different single driver deselects or discharges wordlines 307, 308. The aggressor wordlines 304, 309 are adjacent to victim wordlines 306, 307. With this routing arrangement, each victim wordline 306, 307 is driven by a different driver. This reduces the problem of discharge overload described above.

As a result of the driver output configuration used in drivers 332, logical row address ordering 320 for patch 0 on the left side is different from logical row address ordering 331 for patch 1 on the right side.

As illustrated in **FIG. 3B****,** left and right wordlines that are activated for accessing each logical row are not longitudinally aligned. Instead, the left and right wordlines of each activated pair are physically offset from one another, in contrast to the aligned wordline pairs of **FIG. 3A****.** For example, the left wordline 308 of logical row 2 is not aligned with the right wordline 307 of the same logical row 2.

In one embodiment, crossovers can be done systematically (e.g., instead of in a pseudorandom fashion). For example, the order of rows to be driven by the drivers can be designed by the following mapping. The list of row numbers for a left patch (see, e.g., left column in example below) (e.g., for patch 0) can be divided into m groups, each having n adjacent lines. Interleaving the groups can be used to generate a list of row numbers for a right patch (see, e.g., right column in example below). This process of reordering/mapping/ interleaving is done at the time of design and manufacture of the memory device. The connections/crossovers pattern can be implemented according to the row numbers as determined by this approach.

In one example, each neighboring pair in the left patch is separated by at least three lines for the driving scheme in the right patch. Specificially, the crossovers can be implemented so that a left row ordering is {0, 1, 2, 3, 4, 5, 6, 7, 8} and a corresponding right row ordering is {0, 3, 6, 1, 4, 7, 2, 5, 8}.

For the example above, if the coupling decreases exponentially as the distances between lines increase, the coupling over three lines in between can be considered negligible. As a result, the total coupling effect in each pair of lines to address a row is reduced down to approximately half of that as if the lines in the right patch were used in the same order as the left patch.

In one embodiment, crossovers are used for both left-side and right-side patches. The crossovers can be distributed to both sides to reduce the crossover complexity and/or cost for connecting drivers to wordlines in each patch.

In various embodiments, the actual layouts of the wordlines may not be simply horizontal, parallel, and/or longitudinally-aligned rows. Instead, more generally, crossovers can be used on both left and right patches, and each wordline of each patch can have an arbitrary layout pattern in any direction (e.g., any angle of direction when moving away from a driver to which it is connected). The layout pattern of any given wordline can be independent of other wordline layout patterns, and each wordline can have a unique layout pattern from other wordlines.

Wordline or other access line relationships can be generally described based on neighboring lines, an average distance between lines, and/or magnitudes of coupling effects between lines. For example, in left patch 0, if line 0 is asserted to address row 0, the magnitude of coupling effects (spacing from line 1) decreases from line 1, to line 2, etc., to line 8. If the lines in patch 1 are also numbered in a similar fashion (with the decreasing order of coupling effects, or the increasing order of line spacing to line 0), the row 1 would be changed to be addressed using line 3, instead of line 1).

In general, access lines may not be routed in a patch or region as completely straight, horizontal lines. For example, a plurality of access lines can be routed substantially in parallel in one or more areas of a patch or region. For example, the parallel access lines in different areas may run in different directions (e.g., instead of horizontally and/or as straight lines). The parallel routing of the access lines can cause a coupling effect such that when one of the access lines is being driven actively, the remaining access lines have induced signals of different magnitudes that decrease as their average distances from the active line increase. The lines having the induced signals can be considered victim lines of the active line, where the active line can be considered as an aggressor that causes the induced signals. For example, the active line can have one or two immediate neighbors (e.g., access lines on both sides of the active line, and having a substantially similarly shortest average distance from the active line); and among the access lines the immediate neighbors have a substantially similarly largest magnitude of induced signals. Away from the active line and the immediate neighbors, there can be one or two second immediate neighbors (e.g., having a substantially similarly average distance that is shorter than the shortest average distance to the immediate neighbors, but longer than the average distances to other lines that are routed in parallel but further away from the active line). As the average distance of a parallel access line to the active access line increases, the magnitude of the induced signal in the parallel line decreases.

In some implementations, each row of memory cells is configured to be driven by two access lines routed in two patches (e.g., a patch configured to the left of a driver region where drivers are configured, and another patch configured to the right of the driver region). It is advantageous to arrange the use of access lines connected to the rows such that the combined induced signals from both patches as applied by victim lines to the rows that are not being actively driven are reduced. For example, the arrangement can be implemented such that when an access line and its immediate neighbor routed in one patch are connected to two respective rows, the corresponding access lines used to drive the same two respective rows are not immediate neighbors in the other patch. When one of the two respective rows is being driven actively, the combined induced signals applied on the other row (e.g., as a victim) is the sum of the induced signals resulting from the both patches. By using the access lines that are not immediate neighbors to each other in the other patch, the magnitude of the induced signal resulting from the access lines being routed in the other patch is reduced (e.g., as compared to using two access lines that are immediate neighbors to each other in the other patch). Preferably, the corresponding access lines used to drive the same two respective rows in the other patch are selected such that the average distance between them is as large as possible to reduce the combined induced signals applied on the other row (e.g., as a victim). In some implementations, the corresponding access lines used to drive the same two respective rows in the other patch are selected such that the combined induced signals applied on the other row is small enough to avoid erroneously activating the other row (e.g., as a victim) that is subjected to the induced signals. When the combined induced signals are sufficiently low to avoid erroneous activation, the use of a driver to drive a corresponding signal to reduce or offset the induced signals can be skipped; and the operations of the drivers can be simplified.

**FIG. 4** shows access lines connected to drivers 412, 414, 416, 418, 420 using crossovers 440, in accordance with some embodiments. Drivers 412, 414, 416, 418, 420 are an example of driver circuitry 112. The access lines (e.g., 404, 405, 406, 407) are an example of access lines 140.

Crossovers 440 are physical configurations that permit the physical routing of access lines to cross one another. For example, the physical routing from the output of driver 416 for access line 407 crosses the physical routing from the output of driver 412 to access line 413. The crossovers 440 are implemented so that electrical isolation between access lines is provided. Also, although the crossovers 440 are illustrated on the right side of the drivers, crossovers 440 can be used on the left side of the drivers and/or a combination of left and right sides.

Crossovers 440 can be implemented in various ways. For example, various combinations of vertical interconnect, vias, bridges, etc., can be used. Also, the routing can implement various angles such as, for example, 45° bends and/or 90° bends.

Logical address order 430 for access lines in a left portion of an array is different than logical address order 431 for access lines in a right portion of the array. The different logical address orders can be achieved because of use of crossovers 440.

For example, access line 404 of logical row 0 is offset and not aligned with access line 413 of logical row 0. The crossover configuration and logical address orders can be repeated within an array as needed to cover the full extent of the array. The number of access lines in a given repeating order can be varied as desired.

The outputs of the drivers as routed by crossovers 440 is an example of outputs 120 from driver circuitry 112.

**FIG. 5** shows wordline drivers 502 having outputs connected to wordlines (e.g., 504, 505), in accordance with some embodiments. Wordline drivers 502 are an example of driver circuitry 112. Wordline drivers 502 are configured so that driver outputs on one side (patch 0) of drivers 502 in a memory array provide logical row order 520 that is different from logical row order 531 on an opposite side (patch 1) of drivers 502. Corresponding logical orders 520, 531 can be replicated and repeated in the array for other rows as desired.

In one embodiment, this logical-to-physical address arrangement is implemented using crossovers 440. In one embodiment, this arrangementis implemented using one or more multiplexers (not shown) connecting the drivers to the wordlines.

In one embodiment, a non-volatile RAM device mitigates electrical coupling between wordlines on a memory die. In the die, two patches of cells are driven by a common set of wordline (WL) drivers, with each WL driver powering a separate wordline in each patch (for two wordlines total). To prevent the single WL driver from powering two wordlines simultaneously, the device uses a logical-to-physical ordering between the two patches so that at most a WL driver only sees one wordline being disturbed by electrical coupling. This, for example, improves the efficiency of the WL drivers without increasing their feature size or compromising the shrinking cell geometries.

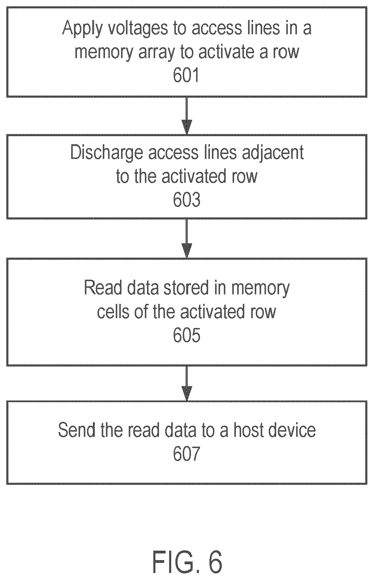

**FIG. 6** shows a method for activating a row in a memory array to read stored data, in accordance with some embodiments. For example, the method of **FIG. 6** can be implemented in the system of **FIG. 1****.**

The method of **FIG. 6** can be performed by processing logic that can include hardware (e.g., processing device, circuitry, dedicated logic, programmable logic, microcode, hardware of a device, integrated circuit, etc.), software (e.g., instructions run or executed on a processing device), or a combination thereof. In some embodiments, the method of **FIG. 6** is performed at least in part by one or more processing devices (e.g., controller 104 of **FIG. 1**).

Although shown in a particular sequence or order, unless otherwise specified, the order of the processes can be modified. Thus, the illustrated embodiments should be understood only as examples, and the illustrated processes can be performed in a different order, and some processes can be performed in parallel. Additionally, one or more processes can be omitted in various embodiments. Thus, not all processes are required in every embodiment. Other process flows are possible.

At block 601, voltages are applied to access lines in a memory array to activate a row. In one example, driver circuitry 112 applies voltages to access lines 140. In one example as shown in **FIG. 4****,** logical row 2 is activated by applying voltages to wordlines 407, 408 using driver 416.

At block 603, access lines adjacent to the activated row are discharged. In one example, adjacent wordline 406 is discharged by driver 414. Adjacent wordline 409 is discharged by a different driver (different from driver 414).

At block 605, data stored in memory cells of the activated row is read. In one example, sense amplifiers 108 read data stored in memory cells 107.

At block 607, the read data is sent to a host device. In one example, the read data is sent to host device 101 using communication interface 116.

In some aspects, the techniques described herein relate to a system including: a plurality of access lines (e.g., 140) configured to provide access to rows of memory cells; and driver circuitry (e.g., 112) configured to drive voltages on the access lines, wherein pairs of the access lines (e.g., each pair has a left wordline and a right wordline) are driven to access respective rows, and wherein access lines of each pair are not longitudinally aligned with each other (e.g., the longitudinal dimensions of the left and right wordlines of each pair are physically offset from one another in the layout for a chip instead of being laid out as aligned and directly across from one another).

In some aspects, the techniques described herein relate to a system, wherein the access lines are wordlines.

In some aspects, the techniques described herein relate to a system, wherein a logical address order (e.g., 0, 1, 2, 3, 4, 5, 6, 7, 8) of access lines on a first side of the driver circuitry is different from a logical address order (e.g., 4, 2, 5, 1, 7, 3, 8, 6, 0 as shown in **FIG. 5**) of access lines on an opposite second side of the driver circuitry.

In some aspects, the techniques described herein relate to a system, wherein first access lines of a first pair are not in linear alignment with each other across a first driver of the driver circuitry.

In some aspects, the techniques described herein relate to a system, wherein the two access lines of each pair are on opposite sides (e.g., an access line in each of patches 0, 1) of the driver circuitry (e.g., wordline drivers 502).

In some aspects, the techniques described herein relate to a system, wherein the access lines are bitlines or digit lines.

In some aspects, the techniques described herein relate to a system, further including sense amplifiers, wherein the access lines include first and second wordlines, a first driver applies at least one voltage to the first and second wordlines to turn on access devices, and data stored in memory cells attached to the access devices is loaded to the sense amplifiers.

In some aspects, the techniques described herein relate to a system, wherein the memory cells are configured in a random access memory (e.g., DRAM or a non-volatile RAM).

In some aspects, the techniques described herein relate to an apparatus including: a plurality of drivers; a plurality of access lines; and a plurality of crossovers (e.g., 440) connecting outputs of the drivers to the plurality of access lines.

In some aspects, the techniques described herein relate to an apparatus, further including a controller configured to cause the drivers to apply voltages to the access lines when accessing a memory array.

In some aspects, the techniques described herein relate to an apparatus, wherein a logical address ordering of first access lines used to access a first portion of rows is different relative to a logical address ordering of second access lines used to access a second portion of the corresponding rows.

In some aspects, the techniques described herein relate to an apparatus, wherein two of the access lines are driven to access a first row, and the two access lines are located on opposite sides of the drivers.

In some aspects, the techniques described herein relate to an apparatus, wherein each crossover includes at least one via or bridge and permits a first access line to physically cross at least one second access line.

In some aspects, the techniques described herein relate to an apparatus, wherein a logical row ordering of access lines on a first side of the drivers is different from a logical row ordering of access lines on a second opposite side of the drivers.

In some aspects, the techniques described herein relate to a memory device including: a plurality of drivers connected to wordlines; and two portions (e.g., left patch 0 and right patch 1 as shown in **FIG. 5**) of memory cells configured for access using the drivers, wherein each driver powers a respective wordline in each portion, and wherein the wordlines are configured with non-aligned logical-to-physical addressing.

In some aspects, the techniques described herein relate to a memory device, wherein when a first logical row having first and second wordlines (e.g., left and right offset wordlines) is activated using a first driver of the drivers, each of the other drivers is configured to power no more than a single one of the wordlines adjacent to the first and second wordlines.

In some aspects, the techniques described herein relate to a memory device, wherein the non-aligned logical-to-physical addressing is implemented using one or more multiplexers connecting the drivers to the wordlines.

In some aspects, the techniques described herein relate to a memory device, further including a controller configured to activate a first row in response to receiving a command from a host device, wherein first and second wordlines of the first row are charged by a first driver.

In some aspects, the techniques described herein relate to a memory device, wherein a third wordline adjacent to the first wordline is discharged by a second driver, and a fourth wordline adjacent to the second wordline is discharged by a third driver.

In some aspects, the techniques described herein relate to a memory device, wherein the second and third drivers discharge the third and fourth wordlines to disable access devices.

The disclosure includes various devices which perform the methods and implement the systems described above, including data processing systems which perform these methods, and computer-readable media containing instructions which when executed on data processing systems cause the systems to perform these methods.

The description and drawings are illustrative and are not to be construed as limiting. Numerous specific details are described to provide a thorough understanding. However, in certain instances, well-known or conventional details are not described in order to avoid obscuring the description. References to one or an embodiment in the present disclosure are not necessarily references to the same embodiment; and, such references mean at least one.

Reference in this specification to "one embodiment" or "an embodiment" means that a particular feature, structure, or characteristic described in connection with the embodiment is included in at least one embodiment of the disclosure. The appearances of the phrase "in one embodiment" in various places in the specification are not necessarily all referring to the same embodiment, nor are separate or alternative embodiments mutually exclusive of other embodiments. Moreover, various features are described which may be exhibited by some embodiments and not by others. Similarly, various requirements are described which may be requirements for some embodiments but not other embodiments.

In this description, various functions and/or operations may be described as being performed by or caused by software code to simplify description. However, those skilled in the art will recognize what is meant by such expressions is that the functions and/or operations result from execution of the code by one or more processing devices, such as a microprocessor, Application-Specific Integrated Circuit (ASIC), graphics processor, and/or a Field-Programmable Gate Array (FPGA). Alternatively, or in combination, the functions and operations can be implemented using special purpose circuitry (e.g., logic circuitry), with or without software instructions. Embodiments can be implemented using hardwired circuitry without software instructions, or in combination with software instructions. Thus, the techniques are not limited to any specific combination of hardware circuitry and software, nor to any particular source for the instructions executed by a computing device.

While some embodiments can be implemented in fully functioning computers and computer systems, various embodiments are capable of being distributed as a computing product in a variety of forms and are capable of being applied regardless of the particular type of computer-readable medium used to actually effect the distribution.

At least some aspects disclosed can be embodied, at least in part, in software. That is, the techniques may be carried out in a computing device or other system in response to its processing device, such as a microprocessor, executing sequences of instructions contained in a memory, such as ROM, volatile RAM, non-volatile memory, cache or a remote storage device.

Routines executed to implement the embodiments may be implemented as part of an operating system, middleware, service delivery platform, SDK (Software Development Kit) component, web services, or other specific application, component, program, object, module or sequence of instructions (sometimes referred to as computer programs). Invocation interfaces to these routines can be exposed to a software development community as an API (Application Programming Interface). The computer programs typically comprise one or more instructions set at various times in various memory and storage devices in a computer, and that, when read and executed by one or more processors in a computer, cause the computer to perform operations necessary to execute elements involving the various aspects.

A computer-readable medium can be used to store software and data which when executed by a computing device causes the device to perform various methods. The executable software and data may be stored in various places including, for example, ROM, volatile RAM, non-volatile memory and/or cache. Portions of this software and/or data may be stored in any one of these storage devices. Further, the data and instructions can be obtained from centralized servers or peer to peer networks. Different portions of the data and instructions can be obtained from different centralized servers and/or peer to peer networks at different times and in different communication sessions or in a same communication session. The data and instructions can be obtained in entirety prior to the execution of the applications. Alternatively, portions of the data and instructions can be obtained dynamically, just in time, when needed for execution. Thus, it is not required that the data and instructions be on a computer-readable medium in entirety at a particular instance of time.

Examples of computer-readable media include, but are not limited to, recordable and non-recordable type media such as volatile and non-volatile memory devices, read only memory (ROM), random access memory (RAM), flash memory devices, solid-state drive storage media, removable disks, magnetic disk storage media, optical storage media (e.g., Compact Disk Read-Only Memory (CD ROMs), Digital Versatile Disks (DVDs), etc.), among others. The computer-readable media may store the instructions. Other examples of computer-readable media include, but are not limited to, non-volatile embedded devices using NOR flash or NAND flash architectures. Media used in these architectures may include un-managed NAND devices and/or managed NAND devices, including, for example, eMMC, SD, CF, UFS, and SSD.

In general, a non-transitory computer-readable medium includes any mechanism that provides (e.g., stores) information in a form accessible by a computing device (e.g., a computer, mobile device, network device, personal digital assistant, manufacturing tool having a controller, any device with a set of one or more processors, etc.). A "computer-readable medium" as used herein may include a single medium or multiple media (e.g., that store one or more sets of instructions).

In various embodiments, hardwired circuitry may be used in combination with software and firmware instructions to implement the techniques. Thus, the techniques are neither limited to any specific combination of hardware circuitry and software nor to any particular source for the instructions executed by a computing device.

Various embodiments set forth herein can be implemented using a wide variety of different types of computing devices. As used herein, examples of a "computing device" include, but are not limited to, a server, a centralized computing platform, a system of multiple computing processors and/or components, a mobile device, a user terminal, a vehicle, a personal communications device, a wearable digital device, an electronic kiosk, a general purpose computer, an electronic document reader, a tablet, a laptop computer, a smartphone, a digital camera, a residential domestic appliance, a television, or a digital music player. Additional examples of computing devices include devices that are part of what is called "the internet of things" (IOT). Such "things" may have occasional interactions with their owners or administrators, who may monitor the things or modify settings on these things. In some cases, such owners or administrators play the role of users with respect to the "thing" devices. In some examples, the primary mobile device (e.g., an Apple iPhone) of a user may be an administrator server with respect to a paired "thing" device that is worn by the user (e.g., an Apple watch).

In some embodiments, the computing device can be a computer or host system, which is implemented, for example, as a desktop computer, laptop computer, network server, mobile device, or other computing device that includes a memory and a processing device. The host system can include or be coupled to a memory sub-system so that the host system can read data from or write data to the memory sub-system. The host system can be coupled to the memory sub-system via a physical host interface. In general, the host system can access multiple memory sub-systems via a same communication connection, multiple separate communication connections, and/or a combination of communication connections.

In some embodiments, the computing device is a system including one or more processing devices. Examples of the processing device can include a microcontroller, a central processing unit (CPU), special purpose logic circuitry (e.g., a field programmable gate array (FPGA), an application specific integrated circuit (ASIC), etc.), a system on a chip (SoC), or another suitable processor.

In one example, a computing device is a controller of a memory system. The controller includes a processing device and memory containing instructions executed by the processing device to control various operations of the memory system.

Although some of the drawings illustrate a number of operations in a particular order, operations which are not order dependent may be reordered and other operations may be combined or broken out. While some reordering or other groupings are specifically mentioned, others will be apparent to those of ordinary skill in the art and so do not present an exhaustive list of alternatives. Moreover, it should be recognized that the stages could be implemented in hardware, firmware, software or any combination thereof.

Disjunctive language such as the phrase "at least one of X, Y, or Z," unless specifically stated otherwise, is otherwise understood with the context as used in general to present that an item, term, etc., may be either X, Y, or Z, or any combination thereof (e.g., X, Y, and/or Z). Thus, such disjunctive language is not generally intended to, and should not, imply that certain embodiments require at least one of X, at least one of Y, or at least one of Z to each be present.

In the foregoing specification, the disclosure has been described with reference to specific exemplary embodiments thereof. It will be evident that various modifications may be made thereto without departing from the broader scope as set forth in the following claims. The specification and drawings are, accordingly, to be regarded in an illustrative sense rather than a restrictive sense.

## Claims

1. A method comprising:
driving voltages on a plurality of access lines (140; 304÷309; 404÷413) configured to provide access to rows (0÷2; 0÷8) of memory cells (107);
wherein pairs of the access lines (304, 309) are driven to access respective rows (0, 0), and wherein access lines (304; 309) of each pair (304, 309) are not aligned with each other.

2. The method of claim 1, wherein the access lines (140; 304÷309; 404÷413) are wordlines.

3. The method of any of the claims from claim 1 to 2, wherein a logical address order (320) of access lines (304,306,308) on a first side of driver circuitry (112; 332) is different from a logical address order (331) of access lines (305, 307, 309) on an opposite second side of the driver circuitry (332).

4. The method of claim 3, wherein first access lines (404, 413; 406, 411; 408;407) of a first pair are not in linear alignment with each other across a first driver (412; 414; 416) of the driver circuitry.

5. The method of any of the claims from claim 1 to 4, wherein the voltages are applied using driver circuitry, and the two access lines of each pair are on opposite sides of the driver circuitry.

6. The method of claim 1, wherein the access lines are bitlines or digit lines.

7. The method of any of the claims from claim 1 to 5, wherein the access lines include first (408) and second (407) wordlines, and the method further comprises:
applying at least one voltage to the first and second wordlines to turn on access devices; and
loading data stored in memory cells (107) attached to the access devices to sense amplifiers (108).

8. The method of any of the claims form claim 1 to 7, wherein the memory cells (107) are configured in a random access memory.

9. An apparatus comprising:
a plurality of drivers (112; 332);
a plurality of access lines (140; 304÷309; 404÷413); and
a plurality of crossovers connecting outputs (120;440) of the drivers (112; 332; 412, 414, 416, 418, ..., 420) to the plurality of access lines.

10. The apparatus of claim 9, further comprising a controller (104) configured to cause the drivers (112; 332; 412÷420) to apply voltages to the access lines (140; 304÷309; 404÷413) when accessing a memory array (106).

11. The apparatus of any of the claims from claim 9 to 10, wherein a logical address ordering (320) of first access lines (304,306,308) used to access a first portion (Patch 0) of rows (0, 1, 2) is different relative to a logical address ordering (331) of second access lines (309, 305, 307) used to access a second portion (Patch 1) of the corresponding rows (0, 1, 2).

12. The apparatus of any of the claims from claim 9 to 11, wherein two of the access lines (304, 309) are driven to access a first row (0), and the two access lines are located on opposite sides of the drivers (332).

13. The apparatus of any of the claims from claim 9 to 12, wherein each crossover comprises at least one via or bridge and permits a first access line to physically cross at least one second access line.

14. The apparatus of any of the claims from claim 9 to 13, wherein a logical row ordering (320; 430) of access lines on a first side of the drivers (332; 412, 414, 416, 418, ..., 420) is different from a logical row ordering (331; 431) of access lines on a second opposite side of the drivers.

15. The apparatus of any of the claims from claim 9 to 14, wherein the access lines (140; 304÷309; 404÷413) are configured with non-aligned logical-to-physical addressing, and the non-aligned logical-to-physical addressing is implemented using one or more multiplexers connecting the drivers (112; 332; 412, 414, 416, 418, ..., 420) to the access lines.
